# EUROPÄISCHE PATENTANMELDUNG

(11) **EP 3 006 201 A1**
(43) Veröffentlichungstag der Anmeldung: **13.04.2016**
(21) Anmeldenummer: 15188633.0
(22) Anmeldetag: 06.10.2015
(51) Int. Cl.: B32B 17/06, B32B 17/10

(54) **MEHRSCHICHTKÖRPER**

(30) Priorität: 06.10.2014 DE 102014114453
(71) Anmelder: blacc GmbH, 49143 Bissendorf (DE)
(72) Erfinder: Gläsner, Holger, 49545 Tecklenburg (DE)
(74) Vertreter: Binder, Armin

(57) **Zusammenfassung**

Es wird ein Mehrschichtkörper vorgestellt, der dadurch gekennzeichnet ist, dass der aus mindestens drei Schichten aufgebaute Mehrschichtkörper (1) zumindest eine Oberschicht (2) und eine Unterschicht (3) aufweist, zwischen denen wenigstens abschnittsweise mindestens eine Dünnfilmglasschicht (4) eingebettet ist.

## Beschreibung

Die Erfindung betrifft einen Mehrschichtkörper, der dem Wortsinn entsprechend aus mehreren Schichten besteht. Derartige Mehrschichtkörper sind bekannt und bereits in unterschiedlichen Ausführungen beziehungsweise Werkstoffkombinationen im Einsatz. Insbesondere die zunehmende Tendenz, Leichtbauwerkstoffe zu erzeugen, führt zu immer neuen Kombinationen unterschiedlicher Materialien, deren Eigenschaften jeweils auf bestimmte Einsatzzwecke abgestimmt sind. Allgemein ist festzustellen, dass hierbei überwiegend Kunststoffe und Faserverbundkunststoffe verwendet werden, um beispielsweise Gewicht einzusparen und dennoch hohe Festigkeitswerte zu erreichen. Aus diesem Grund wird in der jüngeren Vergangenheit vermehrt dazu übergegangen, derartige Kunststoffe und Faserverbundkunststoffe weiterzuentwickeln. Jedoch stoßen Kunststoffe und Faserverbundkunststoffe vielfach an Ihre Belastungsgrenzen, wenn beispielsweise thermische oder chemische Einflüsse beachtet werden müssen. Ebenso wiesen viele Kunststoffe und deren Verbunde eine gewisse Empfindlichkeit gegenüber ultravioletter Strahlung auf. Sind derartige Mehrschichtkörper einmal hergestellt und in ihre endgültige Form gebracht, so lässt sich zudem nach dem Aushärten eine erneute Umformung gar nicht oder nur unter erschwerten Bedingungen realisieren. Dies hat zur Folge, dass verstärkt nach alternativen Mehrschichtkörpern gesucht wird, die die zuvor genannten, nachteiligen Eigenschaften nicht oder nur in begrenztem Umfang aufweisen.

Der Erfindung liegt die Aufgabe zugrunde, einen Mehrschichtkörper bereitzustellen, der thermisch und chemisch sowie gegenüber ultravioletter Strahlung beständig ist und der einfach hergestellt und umgeformt werden kann.
Die Erfindung löst diese Aufgabenstellung mit den Merkmalen des Patentanspruches 1.

Weitere Ausgestaltungen der Erfindung sind Gegenstand der nachfolgenden Unteransprüche.

Ein erfindungsgemäßer Mehrschichtkörper ist dadurch gekennzeichnet, dass der aus mindestens drei Schichten aufgebaute Mehrschichtkörper zumindest eine Oberschicht und eine Unterschicht aufweist, zwischen denen wenigstens abschnittsweise mindestens eine Dünnfilmglasschicht eingebettet ist.

Bei der Dünnfilmglasschicht handelt es sich vorliegend um eine echte Glasschicht, die keine metallischen, also elektrisch leitenden Bestandteile aufweist. Folgerichtig besteht diese Dünnfilmglasschicht überwiegend aus Siliciumdioxid (SiO2). Weitere Bestandteile der Dünnfilmglasschicht können zum Beispiel Aluminiumdioxid, Natriumoxid, Kaliumoxid, Magnesiumoxid, Calciumoxid, Bortrioxid, Bleioxid, Titandioxid und/oder Schwefeltrioxid sein. Darüber hinaus können Zusätze wie Kalk, Natron, Aluminiumdioxid, Phosphorpentoxid, Bortrioxid, Halogenidion, Schwefel, Stickstoff und/oder Alkalioxide in der Dünnfilmglasschicht enthalten sein.

Der Vorteil des Einsatzes einer Dünnfilmglasschicht innerhalb eines Mehrschichtkörpers ist insbesondere in ihren mechanischen Kennwerten, ihrer chemischen und thermischen Beständigkeit sowie in ihrer Unempfindlichkeit gegenüber ultravioletter Strahlung zu sehen. Damit ergibt sich eine sehr breite technische Anwendungspalette für einen derartigen Mehrschichtkörper, der insbesondere für Leichtbauanwendungen geeignet ist, wie sie zum Beispiel im Bereich des Automobilbaus, des Fahrzeugbaus, des Maschinen- und Anlagenbaus, in der Luft- und Raumfahrt sowie im Sport- und Freizeitbereich zum Einsatz kommen können. Maßgeblich für die vorliegende Erfindung ist dabei, dass die Oberschicht und die Unterschicht nicht nur Kunststoffe beziehungsweise Faserverbundwerkstoffe sein, sondern im einfachsten Fall beispielsweise eine Farbschicht darstellen können, wobei andere Materialkombinationen möglich sind. Von Bedeutung ist hierbei lediglich, dass eine dauerfeste Verbindung der Oberschicht und der Unterschicht mit der Dünnfilmglasschicht möglich ist.

Wenn im erfindungsgemäßen Sinne von einer Dünnfilmglasschicht gesprochen wird, so ist damit nicht eine Glasscheibe im herkömmlichen Sinne zu verstehen, sondern vielmehr eine folienartige Dünnfilmglasschicht mit einer Materialstärke zwischen 0,001 mm bis 1,1 mm. Bevorzugte Materialstärken der Dünnfilmglasschicht liegen dabei im Bereich zwischen 0,001 mm bis 0,2 mm.

Die Ausführung der erfindungsgemäßen Dünnfilmglasschicht als extrem dünne, folienartige Schicht bedeutet auch, dass diese mittels eines Warmumformverfahrens oder mittels eines Kaltumformverfahrens elastisch oder plastisch verformbar ist. Die elastische beziehungsweise plastische Verformbarkeit erweitert die Anwendungsvielfalt in erheblichem Maße. Diese besondere Eigenschaft der Dünnfilmglasschicht ermöglicht es nämlich, den Mehrschichtkörper nach der Erfindung nahezu beliebig umzuformen, was sogar Fertigungsverfahren wie Bördeln oder Klemmen einschließt. Mit anderen Worten besteht hiermit erstmals die Möglichkeit, einen Mehrschichtkörper mit einer Dünnfilmglasschicht um andere Bauelemente herum zu formen. Dies eröffnet völlig neue Horizonte für die Anwendung und Verarbeitung eines derartigen Mehrschichtkörpers.
Im losen Mehrschichtverbundkörper können dickere Bauteile kalt umgeformt und interne Spannungen reduziert werden. Die Form und Gestalt wird durch das Verbinden der Einzelschichten gesichert.

Im festen Verbund erfolgt die Umformung beispielsweise mittels eines Warmumformprozesses. Dabei wird eine Ausgleichsschicht, die Unterschicht, Oberschicht und/oder die Dünnfilmglasschicht erwärmt.

Die Verwendung derartiger Mehrschichtkörper ermöglicht die wirtschaftliche und hochqualitative Fertigung hochbelastbarer und beständiger Strukturbauteile.

Zur Verbindung der einzelnen Schichten des erfindungsgemäßen Mehrschichtkörpers ist es von besonderem Vorteil, wenn der Mehrschichtkörper durch ein thermisches Fügeverfahren hergestellt werden kann und auch thermisch umformbar ist. Als Beispiel für ein derartiges Umformverfahren sei an dieser Stelle das "Thermoformen" erwähnt. Das Fügen kann hierbei vor oder nach der Umformung vorgenommen werden.

Eine praktische Umsetzung dieser Weiterbildung der Erfindung zur Herstellung des Mehrschichtkörpers ist beispielsweise darin zu sehen, dass zwischen der Oberschicht und der Unterschicht zunächst eine Schicht aus Glaspulver eingebracht wird und die auf diese Weise zusammengestellte Baugruppe anschließend in einem Ofen erhitzt, also gebacken wird. Während der Erhitzung schmilzt das Glaspulver zu einer Dünnfilmglasschicht und verbindet sich gleichfalls mit der Oberschicht und der Unterschicht zu einem beständigen Mehrschichtkörper, wobei auch ein teilweises Eindringen der Dünnfilmglasschicht in die Oberschicht und/oder die Unterschicht möglich und im Sinne der Erfindung ist. Je nach Temperatureinfluss kann dadurch sogar ein Einschichtkörper erzeugt werden, nämlich, wenn die Einzellagen derart erhitzt werden, dass sie vollständig miteinander verschmelzen. Der fertigungstechnische Aufwand für die Herstellung eines derartigen Mehrschichtkörper ist verhältnismäßig gering, so dass dieser auch kostengünstig erzeugt werden kann.
Das genannte Beispiel ist natürlich nicht einschränkend zu sehen. Vielmehr besteht davon abgesehen auch die Möglichkeit, den Mehrschichtkörper auch ohne Zugabe eines weiteren Matrixwerkstoffes herzustellen. Hierbei werden ganz allgemein die Oberschicht und die Unterschicht des noch losen Schichtverbundes unter Erwärmung im Bereich der Erweichungstemperatur oder darüber hinaus und mit oder ohne eine zusätzliche Krafteinwirkung zu einem Einschichtkörper miteinander verschmolzen. Beim Verschmelzen des Mehrschichtkörpers zu einem Einschichtkörper kann die Kunststoffmatrix substituiert werden. Durch die homogenen Dünnfilmglasschichten kann die sehr gleichmäßige Faserformteil und Glasmatrixverteilung garantiert werden. Die Anbindung der Fasern direkt an die Matrix wird verbessert.

Durch den Schichtaufbau aus Dünnfilmglasschicht und Ober- und Unterschicht kann der Faservolumenanteil exakt eingestellt werden. Die Anbindung an die Fasern der Ober- und Unterschicht erfolgt direkt durch den Werkstoff der Dünnfilmglasschicht. Durch dieses Vorgehen kann die Lage, Orientierung und der Verlauf der Fasern in der Matrix exakt und flexibel vorgenommen werden. Der Lagenaufbau kann variiert und den zu erwartenden Belastungen entsprechend angepasst werden. So sind gegenüber konventionellen Verfahren erstmalig komplexe Faserformteile und -verläufe in einem Einoder Mehrschichtkörper aus Glas realisierbar. Die Fasern stellen dabei den lasttragenden Teil und den größten Volumenanteil dar.

Durch den präzisen Schichtaufbau, ein großes Faservolumen und ununterbrochene Laststränge wird die Leistungsfähigkeit gegenüber konventionellen Faserverbundkunststoffbauteilen deutlich verbessert.

Durch die Aufbringung einer Kraft und durch Erwärmung können derartige Mehrschichtkörper auch geschweißt werden, was beispielsweise durch ein Reibschweißverfahren möglich ist.

Die Ausgestaltung des Mehrschichtkörpers zu einem waben- oder wellenförmigen Leichtbaukern ist möglich. Dieser kann mit Deckflächen zu einem Sandwich verklebt oder verschweißt werden.

Betrachtet man nun die zuvor beschriebene Vorgehensweise eingehender, so lassen sich darüber hinaus die Eigenschaften des erfindungsgemäßen Mehrschichtkörpers weiter verbessern, indem beispielsweise in die Dünnfilmglasschicht Fasern eingebettet werden oder die Dünnfilmglasschicht mit Fasern beschichtet ist. Derartige Fasern können der Erfindung entsprechend beliebige Arten Fasern sein, also beispielsweise Glasfasern, Vliese, Kohlenstofffasern, Aramidfasern oder andere. Diese Einbettung von Fasern unmittelbar in die Dünnfilmglasschicht bringt vollkommen neue Eigenschaften hervor, die beispielsweise in einer verbesserten Umformbarkeit und in einer Optimierung des Biege- und Dehnverhaltens zu sehen sind.

Die Eigenschaften können ebenfalls verbessert werden, indem beispielsweise in die Dünnfilmglasschicht eine Graphenschicht eingebettet wird oder die Dünnfilmglasschicht mit Graphen beschichtet wird.

Wie eingangs bereits ausgeführt wurde, kann die Oberschicht und/oder die Unterschicht je nach Anwendungsfall aus verschiedenen Werkstoffen bestehen. Eine Möglichkeit besteht entsprechend einer Ausgestaltung der Erfindung darin, dass die Oberschicht und/oder die Unterschicht zumindest abschnittsweise aus einem Kunststoff oder einem Faserverbundkunststoff besteht. Kunststoffe und Faserverbundkunststoffe haben den wesentlichen Vorzug, dass sie einfach zu verarbeiten sind und sich optimal mit der Dünnfilmglasschicht verbinden lassen. Folglich ist der fertigungstechnische Aufwand zur Herstellung eines derartigen Mehrschichtkörpers begrenzbar.

Wie festgestellt werden konnte, weist die Dünnfilmglasschicht besonders vorteilhafte Hafteigenschaften auf, wenn sie durch ein Spritzverfahren aus einer Schmelze hergestellt wird. Diese Eigenschaft kann für das Fügen oder die Herstellung des Mehrschichtkörpers dahingehend genutzt werden, dass dadurch die durch ein Spritzverfahren hergestellte Dünnfilmglasschicht durch das Spritzverfahren mit der Ober- und/oder mit der Unterschicht verbunden wird. Im Ergebnis ergibt sich hieraus ein sehr fester Verbund unterschiedlicher Werkstoffe mit ganz neuen Eigenschaften.

Durch die hervorragenden Hafteigenschaften kann durch die im Spritzverfahren hergestellte Dünnglasschicht auch eine stoff-, form- und/oder kraftschlüssige Verbindung zwischen dem Mehrschichtverbund und einem Anschlusselement, beispielweise einem metallischen, keramischen und kunststofflichen Gewindeelement, realisiert werden. Diese Verbindungen sind zudem thermisch lösbar.

Ein ganz wesentlicher Vorzug einer erfindungsgemäß zum Einsatz kommenden Dünnfilmglasschicht als Zwischenschicht zwischen einer Oberschicht und einer Unterschicht besteht darin, dass Glas ein durchsichtiger oder durchscheinender Werkstoff und damit lichtdurchlässig beziehungsweise optisch klar ist. In Abhängigkeit von der Ausführung der Oberschicht beziehungsweise der Unterschicht können daher mit einem erfindungsgemäßen Mehrschichtkörper verschiedene technische und gestalterische Lösungen umgesetzt werden, wenn die Dünnfilmglasschicht durchsichtig ausgeführt ist. So lassen sich hiermit optisch ansprechende Gestaltungen ausführen. Gedacht ist hierbei zum Beispiel an Schilder für Werbungszwecke oder an einen Mehrschichtkörper, der für Beleuchtungszwecke verwendet wird.

Diesem Gedanken folgend lässt sich die Dünnfilmglasschicht darüber hinaus auch mit einem Farbstoff einfärben, was die Gestaltungsmöglichkeiten eines derartigen Mehrschichtkörpers zusätzlich erheblich erweitert.

Um beispielsweise durch thermische oder mechanische Einflüsse verursachte Spannungen innerhalb des Mehrschichtkörper optimal ausgleichen zu können, geht eine Ausgestaltung der Erfindung dahin, dass zumindest eine Ausgleichsschicht zwischen der Dünnfilmglasschicht und der Unterschicht oder zwischen der Dünnfilmglasschicht und der Oberschicht oder zwischen der Dünnfilmglasschicht, der Unterschicht und der Oberschicht angeordnet ist.

Eine derartige Ausgleichsschicht ist insbesondere von Vorteil, wenn die Ober- und/oder Unterschicht aus einem Werkstoff besteht, der dazu neigt, zu schrumpfen beziehungsweise sich auszudehnen beziehungsweise wenn der gesamte Mehrschichtkörper mechanischen Verformungen unterliegt. Dem Gedanken dieses Vorschlages folgend sollte die Ausgleichsschicht daher Spannungen kompensierende Eigenschaften aufweisen.

Dementsprechend kann die vorgeschlagene Ausgleichsschicht eine Kunststoffschicht, eine Harzschicht, eine Gelschicht oder eine Klebstoffschicht mit elastischen Eigenschaften sein. Wird als Ausgleichsschicht eine Klebstoffschicht verwendet, so ist diese gleichfalls nutzbar, um eine Verbindung der Dünnfilmglasschicht mit der Ober- und der Unterschied zu gewährleisten.

Zur Verbesserung der Bruchfestigkeit einer erfindungsgemäßen Dünnfilmglasschicht ist es darüber hinaus von Vorteil, wenn in die Dünnfilmglasschicht die Bruchfestigkeit der Dünnfilmglasschicht steigernde oder auch schwächende Strukturen eingearbeitet sind. Diese Strukturen werden bevorzugt derart angeordnet, dass die zu erwartenden Belastungen der Dünnfilmglasschicht ausgeglichen werden können.

Derartige Strukturen können beispielsweise mikroskopisch kleine Einschnitte oder Erhebungen sein, die bevorzugt in die Oberfläche der Dünnglasschicht eingebracht beziehungsweise aus dieser herausgearbeitet sind.

Darüber hinaus ist es möglich, diese Strukturen beispielsweise mittels eines Ätzverfahrens oder mittels eines Laserschneidverfahrens einzubringen, wobei diese Strukturen in die Oberfläche der Dünnfilmglasschicht oder in den Grundwerkstoff der Dünnfilmglasschicht eingearbeitet werden können.
Bei einem erfindungsgemäßen Mehrschichtkörper kann die Oberschicht und/oder die Unterschicht aus einem Faserverbundwerkstoff mit Kunststoffmatrix oder aus einem Faserverbundwerkstoff mit Elastomer- oder Kautschukmatrix oder aus einem metallischen oder keramischen Werkstoff oder aus einer Kohlenstoffschicht bestehen.

Darüber hinaus kann die Oberschicht und/oder die Unterschicht aus einem sich über den gesamten Mehrschichtkörper erstreckenden und ununterbrochenen, lasttragenden Strang bestehen.

Die Oberschicht und die Unterschicht kann ferner aus einem Formteil aus Endlosfasern wie zum Beispiel Gewebe, Gelege, Geflechte, Gitterstrukturen, Wabenstrukturen 3D-Gewebe oder Kombinationen, aus Kurz-, Langfasern oder Endlosfasern wie zum Beispiel Rovings, Filamanten, Vliesen gebildet werden.

Die Oberschicht und die Unterschicht ist vorteilhaft auch aus einem Formteil aus Fasern wie beispielsweise Kohlenstoff-, Basalt-, Keramik-, Glas-, Metallfasern oder Kombinationen herstellbar.

Weiterhin kann die Oberschicht und die Unterschicht aus Nanopartikeln wie beispielsweise CNT's oder aus Graphen bestehen.

Bei einem Mehrschichtkörper nach der Erfindung kann die Oberschicht und die Unterschicht wenigstens abschnittsweise oder teilweise in die Dünnfilmglasschicht eindringend ausgeführt werden.

Besonders bevorzugt ist eine Ausführung, bei der die Oberschicht und Unterschicht ganz oder teilweise die Dünnfilmglasschicht durchdringen und einen Durchdringungsverbundwerkstoff mit neuen Eigenschaften bilden.

Bei dem Mehrschichtkörper bildet die Dünnfilmglasschicht den Matrixwerkstoff, der durch Verschmelzen mit der Oberschicht und der Unterschicht einen neuen Einschichtkörper erzeugt.

Die Oberschicht und/oder die Unterschicht können Fasern aufweisen und die Oberschicht und die Unterschicht können ganz oder teilweise mit der Dünnfilmglasschicht verbunden sein.

Bei einem erfindungsgemäßen Mehrschichtkörper ist auch vorgesehen, dass die Fasern der Oberschicht und der Unterschicht durch thermisches Aufschmelzen der Dünnfilmglasschicht mit oder ohne Krafteinwirkung stoff-, kraft- und/ oder formschlüssig verbunden sind.

Weiterhin kann der Mehrschichtkörper gebildet werden, indem die Fasern der Oberschicht und der Unterschicht durch mindestens teilweises thermisches Aufschmelzen von Pulver, wie beispielsweise Glaspulver oder Kohlenstoffpulver, und mindestens teilweises Aufschmelzen der Dünnfilmglasschicht mit oder ohne Krafteinwirkung stoff-, kraft- und/ oder formschlüssig verbunden werden.

Ein Mehrschichtkörper nach der Erfindung ist auch dadurch gekennzeichnet, dass die Fasern der Oberschicht und der Unterschicht durch thermisches Aufschmelzen bei 500 bis 850°C oder bei 400 bis 1100°C mit der Dünnfilmglasschicht mit oder ohne Krafteinwirkung verbunden werden.

Ebenso können die Fasern der Oberschicht und der Unterschicht durch thermisches Aufschmelzen im Vakuum mit der Dünnfilmglasschicht mit oder ohne Krafteinwirkung zu einem Mehrschichtkörper verbunden werden.

Weiter können die Fasern der Oberschicht und der Unterschicht durch thermisches Aufschmelzen mittels Mikrowellenanregung mit der Dünnfilmglasschicht mit oder ohne Krafteinwirkung zu einem Mehrschichtkörper verbunden werden.

Bevorzugt weisen die Fasern der Oberschicht und der Unterschicht ganz oder teilweise einen Faservolumenanteil von >50%, von >60% oder von >70% des Mehrschichtkörpers auf.

Ebenso ist vorgesehen, dass der Faservolumengehalt in der Dünnfilmglasschicht >50%, >60% oder >70% beträgt.

Bei einem Mehrschichtkörper stellt die Dünnfilmglasschicht den Matrixwerkstoff für die Fasern der Oberschicht und der Unterschicht ganz oder teilweise dar.

Bevorzugt werden die Fasern der Oberschicht und der Unterschicht geordnet auf die Dünnfilmglasschicht aufgebracht.

Weiterhin können die Fasern der Oberschicht und der Unterschicht orientiert oder ungeordnet auf die Dünnfilmglasschicht aufgebracht sein.

Bei dem Mehrschichtkörper sind vorteilhafterweise die Kunststoffmatrix der Oberschicht und der Unterschicht durch thermisches Aushärten mittels Mikrowellenanregung mit der Dünnfilmglasschicht mit oder ohne Krafteinwirkung zu einem Mehrschichtkörper verbunden.

Die Oberschicht und die Unterschicht weisen jeweils eine Schichtstärke von <0,1mm oder <0,2 mm oder <0,5 mm auf.

Die Dünnfilmglasschicht des Mehrschichtkörpers ist optimal in einer Schichtstärke von <0,1mm, <0,2mm oder von <0,5mm ausgeführt.

Die durch das Spritzverfahren hergestellte Dünnglasschicht bildet vorzugsweise zumindest teilweise eine stoff-, form- und/ oder kraftschlüssige Verbindung mit Oberschicht, Unterschicht und/oder einem Anschlusselement.

Ebenso kann die durch das Spritzverfahren hergestellte Dünnglasschicht zumindest teilweise eine stoff-, form- und/ oder kraftschlüssige Verbindung mit Anschlusselementen, Oberschicht, Unterschicht und/oder elektronischen Bauteilen, wie Leuchten, Schalter, Sensoren, Leuchtelementen oder Platinen bilden.

Mittels eines Reibschweißverfahrens ist es möglich, zumindest teilweise eine stoff-, form- und/ oder kraftschlüssige Verbindung mit Oberschicht, Unterschicht und/ oder einem Anschlusselement herzustellen.

Die Formgebung des Mehrschichtkörpers im losen Verbund der Schichten erfolgt bevorzugt bei <100°C oder bei <250°C oder bei <850°C.

Die Form und Gestalt des Mehrschichtkörpers wird in vorteilhafter Weise durch Aushärten des Matrixwerkstoffes der Oberschicht erreicht, wobei die Unterschicht beibehalten bleibt.

Die Formgebung des Mehrschichtkörpers kann auch unter Erweichen oder Aufschmelzen des Matrixwerkstoffes der Oberschicht, beziehungsweise der Unterschicht erfolgen.

Eine andere Lösung besteht darin, dass die Formgebung und Gestaltung des Mehrschichtkörpers durch Verschweißen der Oberschicht und der Unterschicht mit der Dünnglasschicht erfolgt.

Es wird darauf hingewiesen, dass die voranstehend genannten Merkmale und Merkmalskombinationen untereinander und insbesondere mit den beanspruchten Merkmalen und Merkmalskombinationen im Rahmen des fachmännischen Wissens beliebig kombiniert werden können.

Die Erfindung wird nachfolgend anhand der beigefügten Zeichnungen näher erläutert. Die gezeigten Ausführungsbeispiele stellen dabei keine Einschränkung auf die dargestellten Varianten dar, sondern dienen lediglich der Erläuterung eines Prinzips der Erfindung.

Gleiche oder gleichartige Bauteile werden stets mit denselben Bezugsziffern bezeichnet. Um die erfindungsgemäße Funktionsweise veranschaulichen zu können, sind in den Figuren nur stark vereinfachte Prinzipdarstellungen gezeigt, bei denen auf die für die Erfindung nicht wesentlichen Bauteile verzichtet wurde. Dies bedeutet jedoch nicht, dass derartige Bauteile bei einer erfindungsgemäßen Lösung nicht vorhanden sind.

Es zeigt:
- Figur 1:: einen Schnitt durch einen Teil einer ersten Ausführungsvariante eines Mehrschichtkörpers,
- Figur 2:: einen Schnitt durch einen Teil einer zweiten Ausführungsvariante eines Mehrschichtkörpers,
- Figur 3:: einen Schnitt durch einen Teil einer dritten Ausführungsvariante eines Mehrschichtkörpers,
- Figur 4:: einen Schnitt durch einen Teil einer vierten Ausführungsvariante eines Mehrschichtkörpers,
- Figur 5:: einen Schnitt durch einen Teil einer fünften Ausführungsvariante eines Mehrschichtkörpers,
- Figur 6:: einen Schnitt durch einen Teil einer sechsten Ausführungsvariante eines Mehrschichtkörpers,
- Figur 7:: einen Schnitt durch einen Teil einer siebenten Ausführungsvariante eines Mehrschichtkörpers,
- Figur 8:: einen Schnitt durch einen Teil einer achten Ausführungsvariante eines Mehrschichtkörpers, und
- Figur 9:: einen Schnitt durch einen Teil einer neunten Ausführungsvariante eines Mehrschichtkörpers.

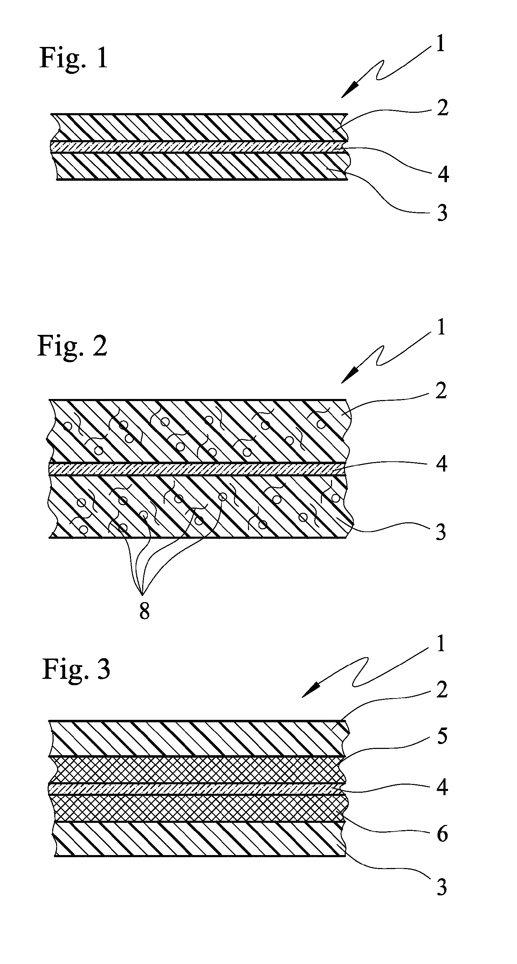

Der in der Figur 1 ausschnittsweise gezeigte Schnittverlauf durch einen Mehrschichtkörper 1 nach der Erfindung veranschaulicht dessen grundsätzlichen Aufbau. Der dargestellte Mehrschichtkörper 1 besteht aus einer Oberschicht 2, die vorliegend aus einem Kunststoff besteht und einer ebenfalls aus Kunststoff hergestellten Unterschicht 3, zwischen denen eine Dünnfilmglasschicht 4 eingebettet ist. Der dargestellte Mehrschichtkörper 1 wird hierbei erzeugt, indem zunächst ein Glaspulver zumindest einseitig auf die Dünnfilmglasschicht 4, zwischen die Oberschicht 2 und die Unterschicht 3 eingestreut und die gesamte Baugruppe im Anschluss daran thermisch so lange erhitzt wird, bis das sich zu der Dünnfilmglasschicht 4 ausbildende Glaspulver mit der Oberschicht 2 und der Unterschicht 3 zu einem Mehrschichtkörper 1 verbunden ist.

Eine besondere Ausführungsvariante eines erfindungsgemäßen Mehrschichtkörpers 1 geht aus der Darstellung in Figur 2 hervor. Hierbei weisen die Oberschicht 2 und die Unterschicht 3 diverse, in diesem Fall strukturlos eingebrachte Fasern 8 auf, bei denen es sich vorliegend um Glasfasern handelt. Durch die als Faserverbundwerkstoff ausgeführte Oberschicht 2 und Unterschicht 3 können die Eigenschaften des Mehrschichtkörpers 1 gezielt beeinflusst werden.

Eine andere Ausführungsvariante eines Mehrschichtkörpers 1 zeigt die Figur 3. Hierbei wurde zum Ausgleich von Spannungen innerhalb des Mehrschichtkörpers 1 die Dünnfilmglasschicht 4 zwischen zwei Ausgleichsschichten 5 und 6 eingebettet, die als Verbindung zwischen der Dünnfilmglasschicht 4 und der Oberschicht 2 sowie der Unterschicht 3 dienen. Die Ausgleichsschichten 5, 6 weisen hierbei elastische Eigenschaften auf und bestehen aus einem elastisch verformbaren Kunststoff oder einem derartigen Klebstoff.

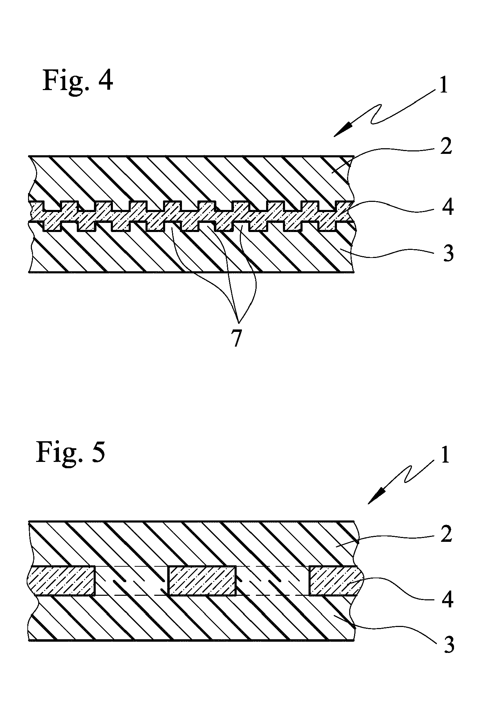

Aus der Darstellung in Figur 4 geht ein weiterer Mehrschichtkörper nach der Erfindung hervor. Hierbei wurden in die Dünnfilmglasschicht 4 beidseitig Strukturen 7 in Form zahlreicher Einschnitte eingebracht, wobei die Besonderheit bei der hier gezeigten Ausführung darin besteht, dass die Einschnitte an der in der Figur 4 dargestellten Oberseite der Dünnfilmglasschicht 4 mit einer dieser gegenüberliegenden Ausformung an der Unterseite der Dünnfilmglasschicht 4 korrespondieren. Mit anderen Worten ausgedrückt, sind die Einschnitte der einander gegenüberliegenden Oberflächen Dünnfilmglasschicht 4 entlang der Ebene der Dünnfilmglasschicht 4 versetzt zueinander angeordnet.

Eine von der Darstellung in Figur 4 abweichende Gestaltung eines Mehrschichtkörpers 1 zeigt die Figur 5. Hierbei weist die zwischen der Oberschicht 2 und der Unterschicht 3 angeordnete Dünnfilmglasschicht 4 eine Vielzahl einzelner Unterbrechungen auf, was dazu führt, dass die Oberschicht 2 beziehungsweise die Unterschicht 3 diese Unterbrechungen durchdringen und damit eine vollständige Integration der Dünnfilmglasschicht 4 in die Ober- beziehungsweise Unterschicht 2, 3 gewährleistet ist. Durch diese Maßnahme wird eine sehr sichere und zuverlässige Verbindung der unterschiedlichen Schichten möglich.

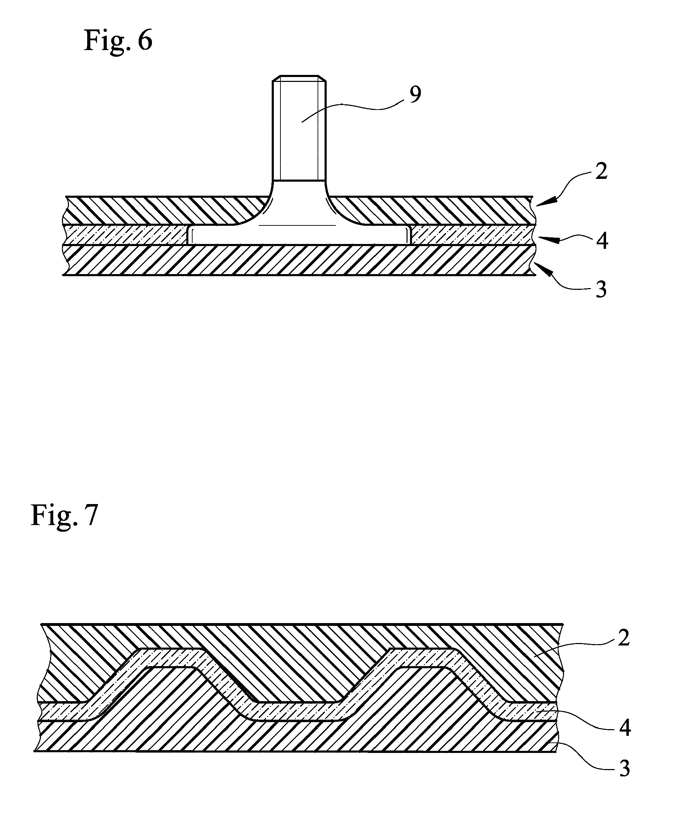

Der aus der Figur 6 hervorgehende Mehrschichtkörper 1 weist innerhalb der Dünnfilmglasschicht 4 mindestens eine Unterbrechung auf, die dazu verwendet wird, ein Anschlusselement 9 einzusetzen, das mit seiner flachen Unterseite auf die Unterschicht 3 aufgesetzt und von der Oberschicht 2 umschlossen ist, sodass es einstückig in den Mehrschichtkörper 1 integriert wird. Bei dem dargestellten Anschlusselement 9 handelt es sich hier nur beispielhaft um ein Bauelement mit einem Gewinde. Die Oberschicht 2 sowie die Unterschicht 3 bestehen hierbei aus einem gießfähigen Kunststoff.

Die Besonderheit der Ausführung eines erfindungsgemäßen Mehrschichtkörpers 1, wie er in der Figur 7 gezeigt ist, besteht darin, dass hierbei die zwischen der Oberschicht 2 und der Unterschicht 3 verlaufende Dünnfilmglasschicht 4 eine wellenförmige Gestalt aufweist, die beispielsweise durch einen nach der Herstellung des Mehrschichtkörpers 1 erfolgenden Stauchvorgang desselben erzeugt werden kann. Eine weitere Möglichkeit der Herstellung einer derartigen Kontur der Dünnfilmglasschicht 4 besteht aber auch darin, dass die Unterschicht 3 zunächst mit einer derartigen Wellenkontur ausgestattet wird und anschließend die Dünnfilmglasschicht 4 aufgeschmolzen oder aufgespritzt wird, bevor als Deckschicht die Oberschicht 2 aufgetragen wird.

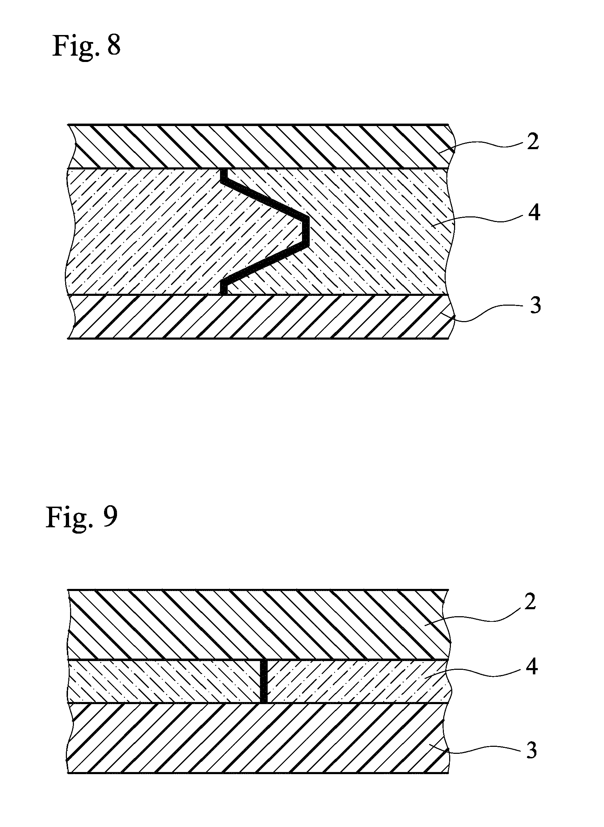

Aus der Figur 8 geht ein Mehrschichtkörper 1 hervor, der die Besonderheit aufweist, dass die Dünnfilmglasschicht 4 aus sandwichartigen Einzelelementen zusammengefügt ist. Hierbei weisen die einzelnen Elemente der Dünnfilmglasschicht 4 jeweils komplementäre Konturen auf, die passend ineinander gefügt werden können. Zur Herstellung einer dauerhaften Verbindung zwischen den einzelnen Elementen der Dünnfilmglasschicht 4 kann beispielsweise ein Laser-Schweißverfahren zum Einsatz kommen, bei dem die einzelnen Elemente miteinander verschweißt werden. Die Oberschicht 2 sowie die Unterschicht 3 bestehen bei diesem Mehrschichtkörper 1 wiederum aus einem Kunststoff.

Ähnlich wie die Ausführung in Figur 8 ist auch die Variante in Figur 9 aufgebaut. Im Unterschied zu der zuvor beschriebenen Lösung werden die einzelnen Elemente der Dünnfilmglasschicht 4 hierbei jedoch in einer Ebene stumpf aneinander gefügt und ebenfalls mittels eines Laser-Schweißverfahrens miteinander verbunden.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen. Insbesondere beschränkt sich die Erfindung nicht auf die nachfolgend angegebenen Merkmalskombinationen, sondern es können auch für den Fachmann offensichtlich ausführbare andere Kombinationen und Teilkombination aus den offenbarten Merkmalen gebildet werden.

### Bezugszeichenliste:

- 1: Mehrschichtkörper
- 2: Oberschicht
- 3: Unterschicht
- 4: Dünnfilmglasschicht
- 5: Ausgleichsschicht
- 6: Ausgleichsschicht
- 7: Struktur
- 8: Faser/Glasfaser
- 9: Anschlusselement

## Patentansprüche

1. Mehrschichtkörper,
**dadurch gekennzeichnet, dass** der aus mindestens drei Schichten aufgebaute Mehrschichtkörper (1) zumindest eine Oberschicht (2) und eine Unterschicht (3) aufweist, zwischen denen wenigstens abschnittsweise mindestens eine Dünnfilmglasschicht (4) eingebettet ist.

2. Mehrschichtkörper nach Anspruch 1,
**dadurch gekennzeichnet, dass**
die folienartige Dünnfilmglasschicht (4) eine Materialstärke zwischen 0,001 mm bis 1,1 mm, bevorzugt 0,001 mm bis 0,2 mm aufweist.

3. Mehrschichtkörper nach einem der vorstehend genannten Ansprüche,
**dadurch gekennzeichnet, dass**
die Oberschicht (2) und/oder die Unterschicht (3) und/oder Dünnfilmglasschicht (4) mittels eines Warmumformverfahrens oder mittels eines Kaltumformverfahrens elastisch oder plastisch verformt ist.

4. Mehrschichtkörper nach einem der vorstehend genannten Ansprüche,
**dadurch gekennzeichnet, dass**
der Mehrschichtkörper (1) durch ein thermisches Fügeverfahren hergestellt ist.

5. Mehrschichtkörper nach einem der vorstehend genannten Ansprüche,
**dadurch gekennzeichnet, dass**
in die Dünnfilmglasschicht (4) Fasern eingebettet sind oder die Dünnfilmglasschicht (4) mit Fasern beschichtet ist.

6. Mehrschichtkörper nach einem der vorstehend genannten Ansprüche,
**dadurch gekennzeichnet, dass**
die Oberschicht (2) und/oder die Unterschicht (3) mindestens abschnittsweise aus einem Kunststoff oder einem Faserverbundkunststoff besteht, der vorzugsweise mit Kohlenstoff-, Basalt-, Keramik-, Glas-, Naturfasern oder metallischen Fasern verstärkt ist und weiter bevorzugt ein Faservolumengehalt >50% aufweist.

7. Mehrschichtkörper nach einem der vorstehend genannten Ansprüche,
**dadurch gekennzeichnet, dass**
zur Herstellung oder zum Fügen des Mehrschichtkörpers (1) die durch ein Spritzverfahren hergestellte Dünnfilmglasschicht (4) durch das Spritzverfahren mit der Ober- und/oder mit der Unterschicht verbunden ist.

8. Mehrschichtkörper nach einem der vorstehend genannten Ansprüche,
**dadurch gekennzeichnet, dass**
die Oberschicht (2) und/oder die Unterschicht (3) aus mindestens einem, sich über den gesamten Mehrschichtkörper erstreckenden und ununterbrochenen, lasttragenden Faserstrang besteht.

9. Mehrschichtkörper nach einem der vorstehend genannten Ansprüche,
**dadurch gekennzeichnet, dass**
zumindest eine Ausgleichsschicht (5, 6) zwischen der Dünnfilmglasschicht (4) und der Unterschicht (3) oder zwischen der Dünnfilmglasschicht (4) und der Oberschicht (2) oder zwischen der Dünnfilmglasschicht (4), der Unterschicht (3) und der Oberschicht (2) angeordnet ist und die Ausgleichsschicht (5, 6) eine Kunststoffschicht, eine Harzschicht, eine Gelschicht oder eine Klebstoffschicht ist.

10. Mehrschichtkörper nach einem der vorstehend genannten Ansprüche,
**dadurch gekennzeichnet, dass**
die Dünnfilmglasschicht (4) sandwichartig oder wellenförmig in dem Mehrschichtkörper (1) angeordnet ist.

11. Mehrschichtkörper nach einem der vorstehend genannten Ansprüche,
**dadurch gekennzeichnet, dass**
die Oberschicht (2) und die Unterschicht (3) aus einem Formteil aus Endlosfasern wie zum Beispiel Gewebe, Gelege, Geflechte, Gitterstrukturen, Wabenstrukturen 3D-Gewebe oder Kombinationen, aus Kurz-, Langfasern oder Endlosfasern wie zum Beispiel Rovings, Filamanten, Vliesen besteht.

12. Mehrschichtkörper nach einem der vorstehend genannten Ansprüche,
**dadurch gekennzeichnet, dass**
die Oberschicht (2) und die Unterschicht (3) aus einem Formteil aus Fasern wie beispielsweise Glas-, Metallfasern oder Kombinationen und bevorzugt aus Kohlenstoff-, Basalt- oder Keramikfasern besteht.

13. Mehrschichtkörper nach Anspruch 11 oder 12,
**dadurch gekennzeichnet, dass**
die Dünnfilmglasschicht (4) den Matrixwerkstoff darstellt und durch Verschmelzen mit der Oberschicht (2) und der Unterschicht (3) einen neuen Einschichtkörper bildet, bei dem die Oberschicht (2) und die Unterschicht (3) jeweils ein aus Fasern gebildetes Formteil sind und die Fasern der Oberschicht (2) und der Unterschicht (3) die Dünnfilmglasschicht (4) ganz oder teilweise durchdringen und bevorzugt die Fasern stoff-, kraft- und/ oder formschlüssig mit der Dünnfilmglasschicht (4) verbunden sind.

14. Mehrschichtkörper nach einem der vorstehend genannten Ansprüche,
**dadurch gekennzeichnet, dass**
in der Oberschicht (2) und der Unterschicht (3) vorhandene Fasern durch thermisches Aufschmelzen von Pulver, wie Glaspulver oder Kohlenstoffpulver, mit oder ohne Krafteinwirkung stoff-, kraft- und/ oder formschlüssig mit der Dünnfilmglasschicht (4) verbunden sind.

15. Mehrschichtkörper nach einem der vorstehend genannten Ansprüche,
**dadurch gekennzeichnet, dass**
durch das Spritzverfahren hergestellte Dünnglasschicht (4) zumindest teilweise eine stoff-, form- und/ oder kraftschlüssige Verbindung mit der Oberschicht (2), der Unterschicht (3) und/oder bevorzugt einem Anschlusselement (9) bildet.
